(19) Europäisches Patentamt
European Patent Office
Office européen des brevets

(11) **EP 2 518 897 A2**

(12) **EUROPEAN PATENT APPLICATION**

(43) Date of publication:
**31.10.2012 Bulletin 2012/44**

(51) Int Cl.:
*H03G 7/00* (2006.01)      *H03G 9/02* (2006.01)
*H03G 9/00* (2006.01)

(21) Application number: **12164888.5**

(22) Date of filing: **20.04.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **28.04.2011  JP 2011102394**

(71) Applicant: **Sony Corporation
Tokyo 108-0075 (JP)**

(72) Inventors:
• **Kono, Akifumi
  Minato-ku, Tokyo 108-0075 (JP)**
• **Chinen, Toru
  Minato-ku, Tokyo 108-0075 (JP)**
• **Tsuji, Minoru
  Minato-ku, Tokyo 108-0075 (JP)**

(74) Representative: **Keston, Susan Elizabeth
D Young & Co LLP
120 Holborn
London EC1N 2DY (GB)**

(54) **Signal processing device, method thereof, program, and data recording medium**

(57)    Provided is a signal processing device including an analysis unit for analyzing a characteristic of an input signal, and generating an analysis feature, a mapping control information determination unit for determining, based on the analysis feature and information that is generated by learning and that is for obtaining mapping control information from the analysis feature, the mapping control information, and a mapping processing unit for performing amplitude conversion on the input signal based on a linear or non-linear mapping function decided based on the mapping control information, and generating an output signal.

**FIG. 1**

**Description**

The present technology relates to a signal processing device, a method thereof, a program, and a data recording medium, and more particularly, to a signal processing device, a method thereof, a program, and a data recording medium.

For example, when reproducing movie content or music content, the dynamic range of whose sound volume is wide, by a portable appliance with a small speaker embedded therein, not only does the overall volume of the sound become small but a dialogue or the like whose volume is particularly low becomes hard to make out.

Thus, as a technology for making the sound of these pieces of content easier to hear, there are normalization and an automatic gain control technology, but unless data of sufficient length is prefetched, volume control becomes unstable from the viewpoint of the sense of hearing.

Furthermore, there is also a technology of boosting a part with a sound with low volume and compressing a part with high volume by using a compression process for a dynamic range of a sound. However, with the compression process, if characteristics of boosting and compression of volume are made applicable to many cases, it would be difficult to obtain a significant effect of sound enhancement, and the characteristics would have to be changed for each piece of content to obtain a significant effect.

For example, there is a technology that takes a sound pressure level specified by dialogue normalization as a reference, and that boosts a signal with a lower sound pressure level and compresses a signal with a higher sound pressure level. However, with this technology, to obtain a sufficient effect, a sound pressure level for dialogue normalization and characteristics regarding boosting and compression have to be specified at the time of encoding an audio signal.

Furthermore, there is also proposed, in relation to a case of compressing the dynamic range of volume of a sound, a technology of making a small sound of an audio signal easier to hear by multiplying the audio signal by a coefficient determined by an average value of an absolute value of the audio signal (for example, see JP H05-275950A).

Now, in recent years, various types of content, such as a movie, music, self-made content and the like, have come to be reproduced by a portable appliance with a small speaker embedded therein. However, many of these pieces of content include no additional information for effective volume control that is based on an advance analysis at the time of encoding as described above. Thus, a technology is desired which performs effective volume control even if additional information obtained by an advance analysis is not added to an audio signal of content.

By using the technology described in JP H05-275950A, a small sound of an audio signal can be made easier to hear by the compression process while suppressing a drastic change in the level of sound, with no advance analysis on the audio signal. However, this technology may not sufficiently enhance the reproduction level of an audio signal.

For example, the technology described in JP H05-275950A merely attenuates the amplitude by constant multiplication of an audio signal, and thus the degree of freedom regarding characteristics of amplitude conversion is restricted and the reproduction level of an audio signal is hardly said to be effectively enhanced. Also, this technology may be used only when narrowing the dynamic range of volume by amplitude conversion of an audio signal, and performing amplitude conversion without changing the dynamic range of volume or widening the dynamic range of volume is not allowed.

The present technology has been made in view of the above circumstances, and enables to more easily and effectively enhance the reproduction level of an audio signal without additional information by an advance analysis.

Various respective aspects and features of the invention are defined in the appended claims. Combinations of features from the dependent claims may be combined with features of the independent claims as appropriate and not merely as explicitly set out in the claims.

Embodiments of the present invention allow easier and more effective enhancement of a reproduction level of an audio signal without additional information by an advance analysis.

According to an embodiment of the present disclosure, there is provided a signal processing device which includes an analysis unit for analyzing a characteristic of an input signal, and generating an analysis feature, a mapping control information determination unit for determining, based on the analysis feature and information that is generated by learning and that is for obtaining mapping control information from the analysis feature, the mapping control information, and a mapping processing unit for performing amplitude conversion on the input signal based on a linear or non-linear mapping function decided based on the mapping control information, and generating an output signal.

The information for obtaining the mapping control information may have been learnt for each signal processing device.

The information for obtaining the mapping control information may be information for obtaining a function for deriving the mapping control information from the analysis feature or a table for obtaining the mapping control information from the analysis feature.

The function may include a term which is uncorrelated to the analysis feature.

The analysis unit may analyse a characteristic of a learning sound-source signal for learning and generate the analysis feature. A learning unit for generating the information for obtaining the mapping control information by learning that uses the analysis feature of the learning sound-source signal and the mapping control information added to the learning sound-source signal by a user may further be provided.

The analysis feature may be a mean square of the input signal, a logged mean square of the input signal, a root mean square of the input signal, a logged root mean square of the input signal, or a zero-crossing rate of the input signal.

In a case amplitude conversion on the input signal is performed for each of a plurality of channels, and the output signal of each channel is generated, the analysis unit may generate one analysis feature that is common to every channel, based on the input signal of each of the plurality of channels.

The signal processing device may further include a band division unit for dividing the input signal into signals of a plurality of frequency bands. The analysis unit may generate the analysis feature by performing weighted addition of mean squares of the signals, logged mean squares of the signals, root mean squares of the signals, or logged root mean squares of the signals.

According to an embodiment of the present disclosure, a signal processing method or a program includes analyzing a characteristic of an input signal, and generating an analysis feature, determining, based on the analysis feature and information that is generated by learning and that is for obtaining mapping control information from the analysis feature, the mapping control information, and performing amplitude conversion on the input signal based on a linear or non-linear mapping function decided based on the mapping control information, and generating an output signal.

According to an embodiment of the present disclosure, a data recording medium records an output signal obtained by analyzing a characteristic of an input signal, and generating an analysis feature, determining, based on the analysis feature and information that is generated by learning and that is for obtaining mapping control information from the analysis feature, the mapping control information, and performing amplitude conversion on the input signal based on a linear or non-linear mapping function decided based on the mapping control information.

According to an embodiment of the present disclosure, a characteristic of an input signal is analysed, an analysis feature is generated, mapping control information is determined based on the analysis feature and information that is generated by learning and that is for obtaining the mapping control information from the analysis feature, amplitude conversion is performed on the input signal based on a linear or non-linear mapping function decided based on the mapping control information, and an output signal is generated.

According to an embodiment of the present disclosure, the reproduction level of an audio signal can be more easily and effectively enhanced without additional information by an advance analysis. [0024]

Embodiments of the invention will now be described with reference to the accompanying drawings, throughout which like parts are referred to by like references, and in which:

FIG. 1 is a diagram showing an example configuration of an embodiment of an audio signal processing device;
FIG. 2 is a diagram showing an example configuration of a learning device;
FIG. 3 is a flow chart describing a learning process;
FIG. 4 is a diagram showing an example of a mapping function;
FIG. 5 is a diagram showing an example of a regression curve based on a mapping control model;
FIG. 6 is a flow chart showing a conversion process;
FIG. 7 is a diagram showing another example configuration of the audio signal processing device;
FIG. 8 is a diagram showing another example configuration of the audio signal processing device;
FIG. 9 is a flow chart describing a conversion process;
FIG. 10 is a diagram showing another example configuration of the audio signal processing device;
FIG. 11 is a flow chart describing a conversion process; and
FIG. 12 is a diagram showing an example configuration of a computer.

(First Embodiment)

[Example Configuration of Audio Signal Processing Device]

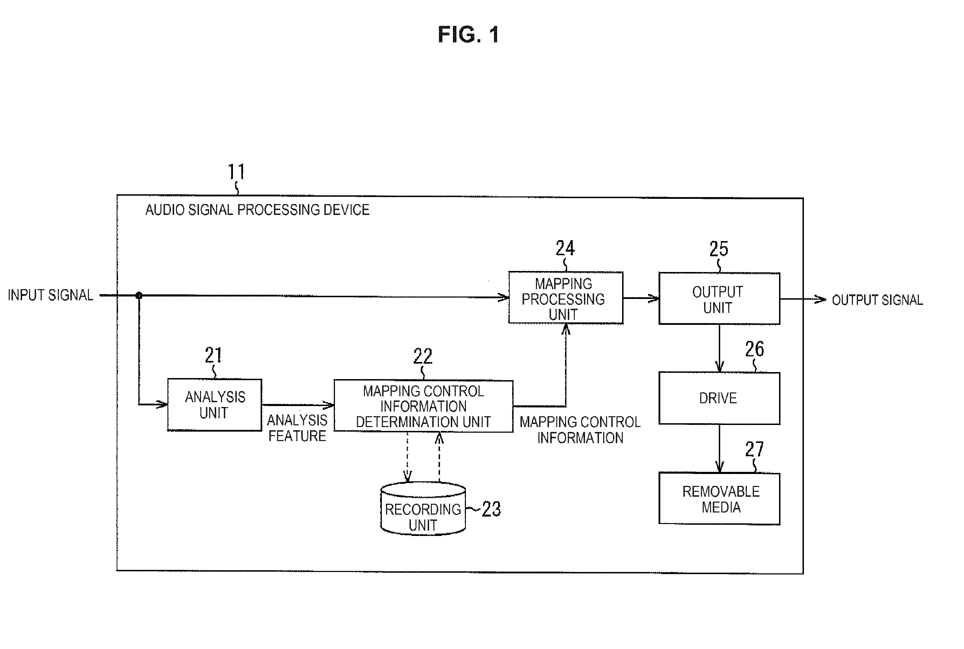

FIG. 1 is a diagram showing an example configuration of an embodiment of an audio signal processing device adopting the present technology.

This audio signal processing device 11 is provided in a portable reproduction device that reproduces content formed by a video signal and an audio signal, for example, and performs amplitude conversion on an input audio signal in such a way that the reproduction level is enhanced, and outputs the audio signal on which amplitude conversion has been performed. Additionally, in the following, an audio signal that is input to the audio signal processing device 11 is referred to as an input signal, and an audio signal obtained by performing amplitude conversion on the input signal is referred to as an output signal.

The audio signal processing device 11 is configured from an analysis unit 21, a mapping control information determination unit 22, a recording unit 23, a mapping processing unit 24, an output unit 25 and a drive 26.

The analysis unit 21 analyses the characteristic of an input signal which has been supplied, and supplies an analysis feature indicating the analysis result to the mapping control information determination unit 22.

The mapping control information determination unit 22 determines, based on the analysis feature supplied from the analysis unit 21 and a mapping control model recorded in the recording unit 23, mapping control information to be used for a mapping process on an input signal, and supplies the same to the mapping processing unit 24.

Additionally, the mapping process is a process performed by the mapping processing unit 24, and with the mapping process, a linear or non-linear mapping function decided based on the mapping control information is used and linear or non-linear amplitude conversion is performed on an input signal. Furthermore, the mapping control model is information used for obtaining the mapping control information from the analysis feature.

The recording unit 23 records the mapping control model supplied from an external device, and supplies the mapping control model to the mapping control information determination unit 22 as necessary.

The mapping processing unit 24 performs, using the mapping control information supplied from the mapping control information determination unit 22, the mapping process on an input signal supplied, and enhances the reproduction level of the input signal. The mapping processing unit 24 supplies an output signal which has been obtained by the mapping process to the output unit 25.

The output unit 25 outputs the output signal, which has been supplied from the mapping processing unit 24, to an audio output unit or the like in the latter stage or supplies the same to the drive 26. The drive 26 records the output signal supplied from the output unit 25, and records the signal in a removable media 27 which is a recording medium that can be freely attached/detached to/from the drive 26.

[Example Configuration of Learning Device]

Generally, a recording level of an input signal differs depending on content, and it would be effective to adjust, by the audio signal processing device, the reproduction level of an input signal by the mapping process to an appropriate level while dynamically changing the characteristic of a mapping function.

However, the level of sound that can be reproduced may differ depending on the audio signal processing device, or the way the sound is heard may differ depending on the user. Thus, if the same mapping control model is used for the mapping process, depending on the audio signal processing device used for reproduction or depending on the user, even if an output signal obtained by the mapping process is reproduced, the volume of the sound may be too loud or too small from the viewpoint of the sense of hearing.

Thus, with the audio signal processing device 11, a mapping control model obtained by performing learning using a plurality of sound sources is used by each audio signal processing device 11, for example, each individual audio signal processing device 11 or each type.

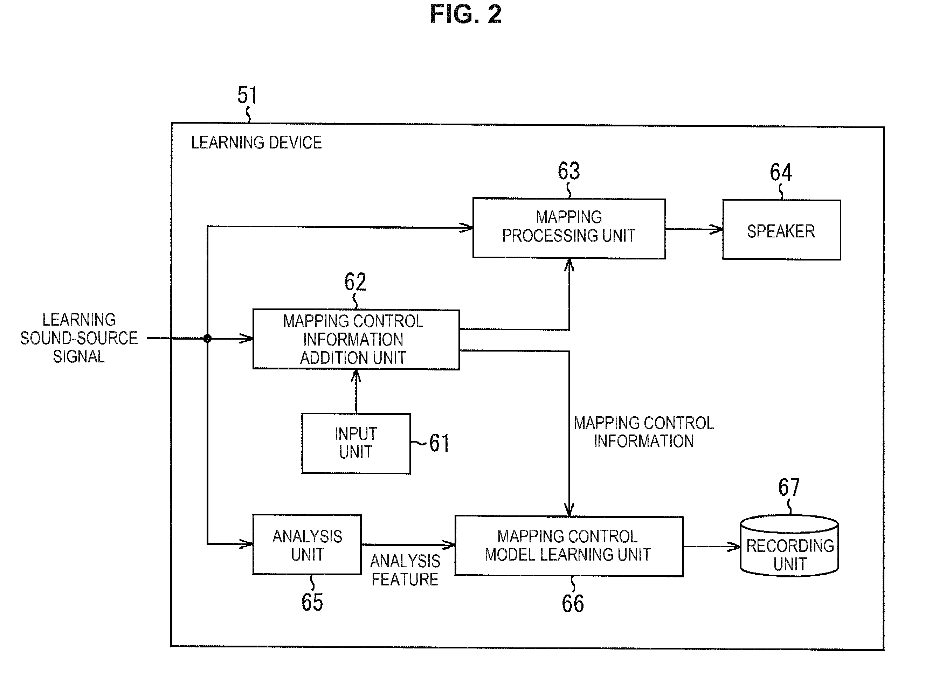

For example, a learning device that obtains, by learning, a mapping control model used by the audio signal processing device 11 is configured as shown in FIG. 2.

A learning device 51 is configured from an input unit 61, a mapping control information addition unit 62, a mapping processing unit 63, a speaker 64, an analysis unit 65, a mapping control model learning unit 66 and a recording unit 67. At the learning device 51, a learning sound-source signal to be used for learning of a mapping control model is supplied to the mapping control information addition unit 62, the analysis unit 65 and the mapping processing unit 63.

The input unit 61 is a button or the like to be operated by a user, for example, and supplies a signal that is in accordance with an operation of the user to the mapping control information addition unit 62. The mapping control information addition unit 62 adds mapping control information to each sample of the learning sound-source signal supplied, according to the signal from the input unit 61, and supplies the same to the mapping processing unit 63 or the mapping control model learning unit 66.

The mapping processing unit 63 performs, using the mapping control information from the mapping control information addition unit 62, a mapping process on the learning sound-source signal supplied, and supplies a learning output signal obtained as a result to the speaker 64. The speaker 64 reproduces sound based on the learning output signal supplied from the mapping processing unit 63.

The analysis unit 65 analyses the characteristic of the learning sound-source signal supplied, and supplies an analysis feature indicating the analysis result to the mapping control model learning unit 66. The mapping control model learning unit 66 obtains a mapping control model by statistical learning that uses the analysis feature from the analysis unit 65 and the mapping control information from the mapping control information addition unit 62, and supplies the same to the recording unit 67.

The recording unit 67 records the mapping control model supplied from the mapping control model learning unit 66. The mapping control model recorded in the recording unit 67 in this manner is supplied and recorded in the recording unit 23 of the audio signal processing device 11.

[Explanation of Learning Process]

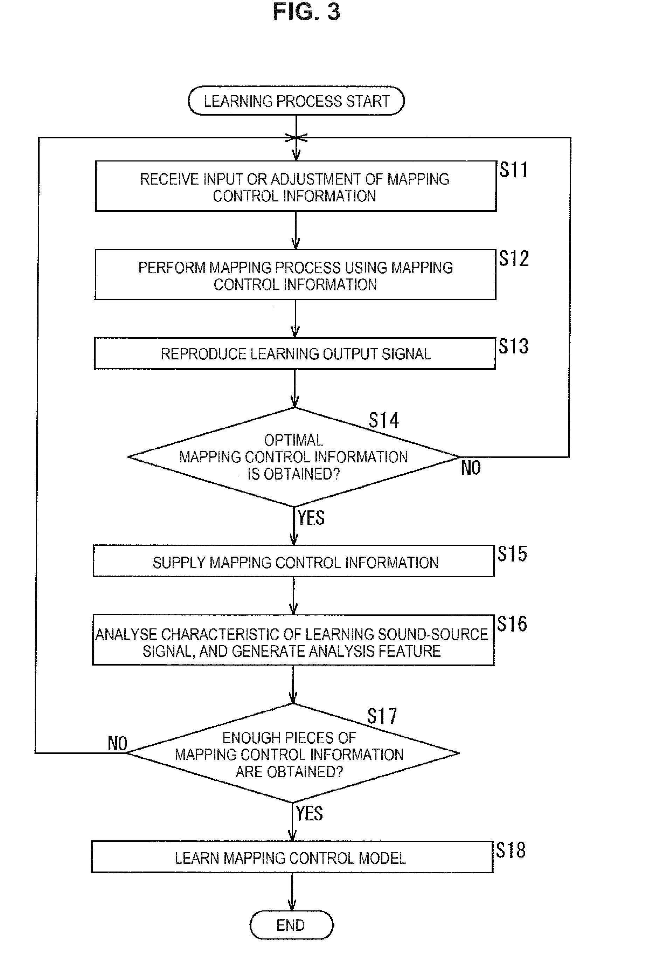

Next, a learning process of the learning device 51 will be described with reference to the flow chart of FIG. 3.

According to this learning process, one or more learning sound-source signals are supplied to the learning device 51. Also, in this case, the analysis unit 65, the mapping processing unit 63, the speaker 64 and the like are assumed to be the same as each of the corresponding blocks, such as the analysis unit 21, the mapping processing unit 24 and the like, of the audio signal processing device 11 to which a mapping control model obtained by learning is supplied. That is, the characteristic of the block or the algorithm for the process is assumed to be the same.

In step S11, the input unit 61 receives, from a user, input or adjustment of mapping control information.

For example, if a learning sound-source signal is input, the mapping processing unit 63 supplies the learning sound-source signal, which has been supplied, to the speaker 64 as it is and causes sound based on the learning sound-source signal to be output. Then, the user, while listening to the sound that is output, operates the input unit 61, taking a predetermined sample of the learning sound-source signal as a process target sample, and gives an instruction for addition of mapping control information to the process target sample.

Additionally, the instruction for the addition of mapping control information is given by the user directly inputting the mapping control information or specifying desired piece from a plurality of pieces of mapping control information, for example. Also, the instruction for the addition of mapping control information may be given by the user giving an instruction for adjustment of mapping control information which had been specified once.

When the user operates the input unit 61 in this manner, the mapping control information addition unit 62 adds the mapping control information to the process target sample according to the operation of the user. Then, the mapping control information addition unit 62 supplies the mapping control information which has been added to the process target sample to the mapping processing unit 63.

In step S12, the mapping processing unit 63 performs, using the mapping control information supplied from the mapping control information addition unit 62, a mapping process on the process target sample of the learning sound-source signal which has been supplied, and supplies a learning output signal obtained as a result to the speaker 64.

For example, the mapping processing unit 63 performs amplitude conversion by substituting a sample value x of the process target sample of the learning sound-source signal into a non-linear mapping function f(x) shown in Formula (1) below. That is, a value obtained by substituting the sample value x into the mapping function f(x) is taken as the sample value of the process target sample of the learning output signal.

$$f(x) = \frac{\alpha}{\alpha - 1}\left(x - \frac{1}{\alpha}x^3\right) \quad (-1.0 \leq x \leq 1.0) \qquad \cdots (1)$$

Additionally, in Formula (1), the sample value x of the learning sound-source signal is assumed to have been normalized so as to be a value between -1 and 1. Also, in Formula (1), $\alpha$ indicates the mapping control information.

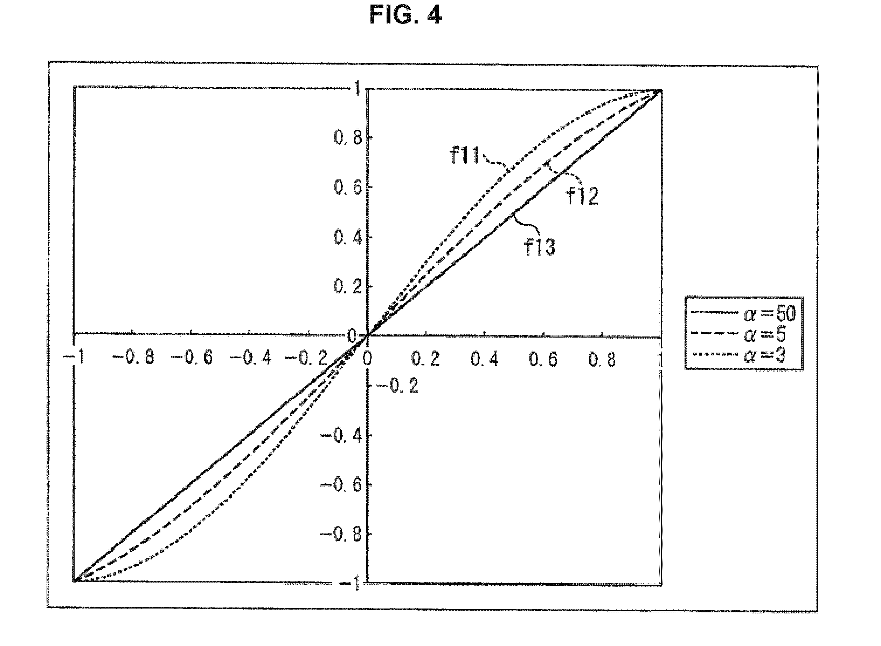

Such a mapping function f(x) is a function that varies more steeply as the mapping control information $\alpha$ becomes smaller, as shown in FIG. 4. Additionally, in FIG. 4, the horizontal axis indicates the sample value x of the learning sound-source signal, and the vertical axis indicates the value of the mapping function f(x). Also, curved lines f11 to f13 express mapping functions f(x) where pieces of mapping control information $\alpha$ are "3," "5" and "50", respectively.

As can be seen from FIG. 4, the amplitude conversion on the learning sound-source signal is performed using a mapping function f(x) according to which the amount of change of f(x) with respect to the change of the sample value x is greater in overall as the mapping control information $\alpha$ is smaller. When the mapping control information $\alpha$ is changed in this manner, the amount of amplification regarding the learning sound-source signal changes.

Returning to the explanation of the flow chart of FIG. 3, in step S13, the speaker 64 reproduces the learning output signal supplied from the mapping processing unit 63.

Additionally, more specifically, a learning output signal that is obtained by performing a mapping process on a predetermined section including the process target sample is reproduced. Here, the section which is the target of reproduction is a section formed from samples for which the mapping control information is already specified, for example. In this case, a mapping process is performed on each sample of the section which is the target of reproduction using the mapping control information specified for these samples, and a learning output signal obtained as a result is reproduced.

When a learning output signal is reproduced in this manner, the user, listening to the sound that is output from the speaker 64, evaluates the effect of the mapping process. That is, whether the volume of the sound of the learning output signal is appropriate is evaluated. Then, the user operates the input unit 61, and based on the result of the evaluation, gives an instruction for adjustment of the mapping control information, or an instruction for fixing the mapping control information specified, assuming that the mapping control information specified is the optimal.

In step S14, the mapping control information addition unit 62 decides, based on a signal that is in accordance with the operation of the user input from the input unit 61, whether optimal mapping control information has been obtained or not. For example, in the case the user gave an instruction for fixing the mapping control information, it is decided that optimal mapping control information had been obtained.

In the case it is decided in step S14 that optimal mapping control information is not yet obtained, that is, in the case an instruction for adjustment of the mapping control information was given, the process returns to step S11, and the above-described process is repeated.

In this case, new mapping control information is added to the sample which is the target of processing, and evaluation of the mapping control information is performed. In this manner, by evaluating the effect of the mapping process while actually listening to the sound of the learning output signal, mapping control information which is optimal from the viewpoint of the sense of hearing can be added.

On the other hand, in the case it is decided in step S14 that optimal mapping control information has been obtained, the process proceeds to step S15. In step S15, the mapping control information addition unit 62 supplies the mapping control information which has been added to the sample which is the target of processing to the mapping control model learning unit 66.

In step S16, the analysis unit 65 analyses the characteristic of the learning sound-source signal supplied, and supplies an analysis feature obtained as a result to the mapping control model learning unit 66.

For example, when assuming that an n-th sample of the learning sound-source signal is the sample which is the target of processing, the analysis unit 65 performs calculation of Formula (2) below, and calculates a root mean square RMS(n) regarding the n-th sample of the learning sound-source signal as the analysis feature of the n-th sample.

$$RMS(n) = 20.0 \times \log_{10}\left(\sqrt{\frac{1}{N} \cdot \sum_{m=n-N/2}^{n+N/2-1}(x(m))^2}\right) \qquad \cdots (2)$$

Additionally, in Formula (2), x(m) indicates the sample value of an m-th sample of the learning sound-source signal (the value of the learning sound-source signal). Also, in Formula (2), the value of the learning sound-source signal, that is, the sample value of each sample of the learning sound-source signal, is assumed to have been normalized such that $-1 \leq x(m) \leq 1$ stands.

Accordingly, the root mean square RMS(n) is obtained by taking, with respect to a section formed from N consecutive samples centring on the n-th sample, a logarithm of the square root of a mean square value of the sample value of the sample included in the section and multiplying the obtained value by a constant "20".

The value of the root mean square RMS(n) obtained in this manner becomes smaller as the absolute value of the sample value of each sample of a specific section having the n-th sample of the learning sound-source signal which is the process target as the centre becomes smaller. That is, the root mean square RMS(n) becomes smaller as the volume of the sound of the whole of the specific section including the process target sample of the learning sound-source signal becomes lower.

Additionally, the root mean square RMS(n) has been described as the example of the analysis feature, but the analysis feature may also be a t-th power value (where $t \geq 2$) of the RMS(n), the zero-crossing rate of the learning sound-source signal, the slope of the frequency envelope of the learning sound-source signal, or a combination thereof.

When the analysis feature is supplied from the analysis unit 65 to the mapping control model learning unit 66 in this manner, the mapping control model learning unit 66 temporarily records the analysis feature obtained for the sample which is the process target and the mapping control information of the sample in association with each other.

In step S17, the learning device 51 decides whether enough pieces of mapping control information have been obtained or not. For example, in the case sets, enough for learning a mapping control model, of analysis feature and mapping control information that are temporarily recorded have been obtained, it is decided that enough pieces of mapping control information have been obtained.

In the case it is decided in step S17 that enough pieces of mapping control information have not been obtained, the process returns to step S11, and the above-described process is repeated. That is, a sample of the learning sound-source signal following the sample which is the current process target is taken as the new process target sample and the mapping control information is added thereto, or the mapping control information is added to a sample of a new learning sound-source signal, for example. Or, a different user may add mapping control information may to a sample of the learning sound-source signal.

In the case it is decided in step S17 that enough pieces of mapping control information have been obtained, the mapping control model learning unit 66 learns, in step S18, a mapping control model, using the sets of analysis feature and mapping control information that are temporarily recorded.

For example, the mapping control model learning unit 66 assumes that mapping control information $\alpha$ can be obtained from an analysis feature by performing calculation of Formula (3) below, and obtains the same by learning, taking the function shown in Formula (3) as the mapping control model.

$$\alpha = a \times F^2 + b \times F + c \qquad \cdots (3)$$

Additionally, in Formula (3), F indicates the analysis feature, and a, b and c are constants. Particularly, the constant c is an offset term which is uncorrelated to the analysis feature F.

In this case, the mapping control model learning unit 66 takes the root mean square RMS(n) and a square value of the root mean square RMS(n) corresponding to F and F2 in Formula (3) as explanatory variables and the mapping control information $\alpha$ as an explained variable, and performs learning of a linear regression model by a least squares method and obtains the constants a, b and c.

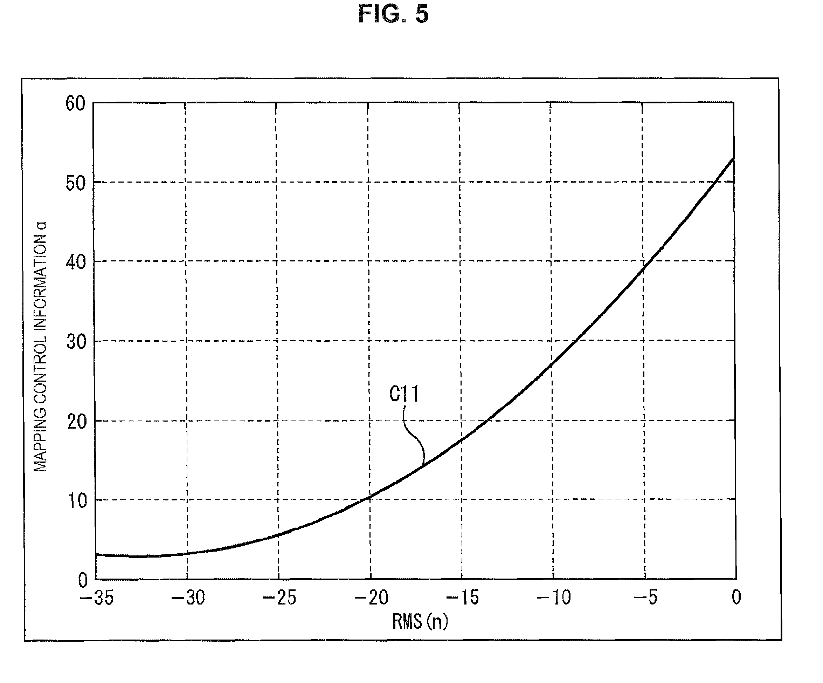

A result shown in FIG. 5 is thereby obtained, for example. Additionally, in FIG. 5, the vertical axis indicates the mapping control information $\alpha$ and the horizontal axis indicates the root mean square RMS(n) as the analysis feature. In FIG. 5, a curved line C11 indicates the value of mapping control information $\alpha$ determined for the value of each analysis feature, that is, the graph of the function indicated in Formula (3) above.

In this example, the value of the mapping control information $\alpha$ becomes smaller as the volume of sound of an audio signal such as the learning sound-source signal or the input signal becomes lower and the analysis feature becomes smaller.

When the constants a, b and c are determined by the learning as described above and a function $aF^2+bF+c$ for obtaining the mapping control information from the analysis feature is obtained, the mapping control model learning unit 66 supplies the function $aF^2+bF+c$ obtained to the recording unit 67 as the mapping control model and causes the recording unit 67 to record the same.

When the mapping control model obtained by learning is recorded in the recording unit 67, the learning process is ended. The mapping control model recorded in the recording unit 67 is then recorded in the recording unit 23 of the audio signal processing device 11 and is used for the mapping process.

The learning device 51 obtains a mapping control model for each audio signal processing device 11 by learning in the above manner, by using a plurality of learning sound-source signals or pieces of mapping control information specified by a plurality of users.

Accordingly, when using the obtained mapping control model, mapping control information that is statistically optimal for the audio signal processing device 11 can be obtained, regardless of the input signal which is the reproduction target or the user who will listen to the reproduced sound. Particularly, if learning is performed using only the mapping control information added by one user, a mapping control model can be created by which mapping control information which is optimal for the user is obtained.

Additionally, in the above, a case where input or adjustment of mapping control information is performed for each sample, with respect to a learning sound-source signal, has been described, but input or adjustment of mapping control information may also be performed for a set of two or more consecutive samples of the learning sound-source signal at a time.

Furthermore, a quadratic equation regarding the RMS(n) is used here as the mapping control model, but a function of the third or higher degree may also be used.

Furthermore, it has been explained that the root mean square RMS(n) and its square value are used as the explanatory variables of the mapping control model, but other analysis features may be arbitrarily added or combined as the explanatory variables. For example, as other analysis features, there may be a t-th power value (where $t \geq 3$) of the root mean square RMS(n), the zero-crossing rate of the learning sound-source signal, the slope of the frequency envelope of the learning sound-source signal, and the like.

[Explanation of Conversion Process]

When a mapping control model supplied from the learning device 51 is recorded in the recording unit 23 of the audio signal processing device 11, it becomes possible to convert an input signal to an output signal with more appropriate volume by using this mapping control model.

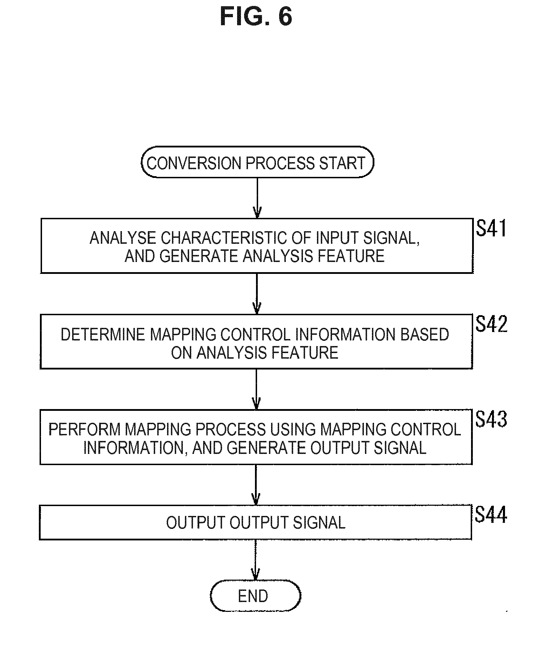

When an input signal is supplied, the audio signal processing device 11 performs a conversion process, generates an output signal and outputs the same. In the following, the conversion process of the audio signal processing device 11 will be described with reference to the flow chart of FIG. 6.

In step S41, the analysis unit 21 analyses the characteristic of the input signal supplied, and generates an analysis feature. Additionally, the same analysis feature as that used for learning is used as the analysis feature.

To be specific, for example, the analysis unit 21 performs calculation of Formula (2) described above, and calculates the root mean square RMS(n) for an n-th sample of the input signal as the analysis feature of the n-th sample.

Additionally, in this case, x(m) of Formula (2) is assumed to be the sample value of an m-th sample of the input signal. Also, at the time of calculation of the root mean square RMS(n) of the input signal, the sample value of each sample of the input signal is assumed to have been normalized such that $-1 \leq x(m) \leq 1$ stands.

Furthermore, the analysis feature of the input signal may also be the mean square value of the input signal, a logged mean square value of the input signal, the square root of the mean square value of the input signal, the t-th power value (where $t \geq 2$) of the RMS(n), the zero-crossing rate of the input signal, the slope of the frequency envelope of the input signal or the like, or may be any combination of these features or other features.

When an analysis feature is obtained, the analysis unit 21 supplies the obtained analysis feature to the mapping control information determination unit 22.

In step S42, the mapping control information determination unit 22 determines mapping control information based on the analysis feature supplied from the analysis unit 21 and a mapping control model recorded in the recording unit 23, and supplies the mapping control information to the mapping processing unit 24.

For example, the mapping control information determination unit 22 performs calculation of Formula (3) based on the function described above recorded as a mapping control model and the analysis feature, and obtains mapping control information $\alpha$.

Additionally, an example has been described where the mapping control model is recorded in the recording unit 23, but information recorded in the recording unit 23 may be any information as long as mapping control information can be obtained from an analysis feature.

For example, a table in which the value of each analysis feature and mapping control information are associated may be recorded in the recording unit 23. In such a case, the mapping control information determination unit 22 refers to the table in the recording unit 23, and supplies the mapping control information that is associated, in the table, with a supplied analysis feature to the mapping processing unit 24.

In step S43, the mapping processing unit 24 performs a mapping process on the input signal supplied, by using the mapping control information supplied from the mapping control information determination unit 22, and generates an output signal. Here, the same function as that used for learning is used as the mapping function f(x).

Specifically, the mapping processing unit 24 substitutes a sample value x of the n-th sample of the input signal into the non-linear mapping function f(x) shown in Formula (1) above, and performs amplitude conversion on the input signal. That is, a value obtained by substituting the sample value x into the mapping function f(x) is taken as the sample value of the n-th sample of the output signal. Additionally, also in this case, the sample value x of the input signal is assumed to have been normalized as to be a value between -1 and 1. Also, in the calculation of Formula (1), the value of the mapping control information is taken as the value of $\alpha$ in Formula (1).

In the case the root mean square RMS(n) is obtained as the analysis feature, since the analysis feature becomes smaller as the volume of the sound of the input signal becomes lower, the value of the mapping control information $\alpha$ also becomes smaller. Also, as shown in FIG. 4, the slope of the mapping function f(x) becomes steeper as the mapping control information $\alpha$ becomes smaller.

Accordingly, amplitude conversion on the input signal is performed using a mapping function f(x) whose characteristic is to change more steeply, in most of the section of the sample x including a sample value x=0, as the overall volume of the sound of the input signal becomes smaller.

As a result, amplitude conversion is performed on the input signal in such a way that, in a section where the overall volume of the sound of the input signal is low, a sound with low volume is converted into a sound with higher volume, and the reproduction level of the input signal is enhanced. Thus, even when reproducing content such as a movie whose dynamic range of volume is wide by a portable appliance with a small speaker embedded therein, a small sound which was hard to make out in the past can be made easier to understand by the mapping process on the input signal.

Furthermore, amplitude conversion on the input signal is performed using a mapping function f(x) whose characteristic is to change moderately steeply for a signal whose sample value x is small, even in a section where the overall volume of the sound of the input signal is high.

As a result, amplitude conversion is performed on the input signal in such a way that, also in a section where the overall volume of the input signal is high, a sound in the section with low volume is converted into a sound with high volume, and the reproduction level of the input signal is enhanced. Thus, a sound which was reproduced relatively loudly in the past is made even louder.

Moreover, with the audio signal processing device 11, amplitude conversion does not have to be performed by first performing an analysis on the input signal in advance and adding additional information for amplitude conversion to the input signal or by first prefetching a long section of the input signal and performing an analysis on the input signal which has been read.

Furthermore, by changing the non-linear mapping function f(x) by the mapping control information α, amplitude conversion can be performed with a higher degree of freedom. That is, by taking a non-linear function with the most effective characteristic as the mapping function according to the characteristic of an entire specific section of an input signal, it is possible to perform amplitude conversion that takes into consideration not only the characteristic of a section in which a sample which is the process target is included but also the size of the sample value of the sample.

For example, according to the technology described in JP H05-275950A mentioned above, an audio signal is multiplied by a constant that is decided by the average value of the absolute value of the audio signal regardless of the value of the audio signal. That is, a sample of the audio signal is multiplied by a constant at all times regardless of the level of the amplitude of the sample.

Thus, if a calculation method of a constant by which an audio signal is multiplied is decided in such a way that the volume of a sound is increased according to a sound with relatively low volume, appropriate volume may not be obtained with respect to a sound with high volume even if the audio signal is multiplied by the constant.

On the other hand, with the audio signal processing device 11, if the mapping function is a non-linear function, amplitude conversion can be performed with a higher degree of freedom in such a way that the amplitude is not greatly changed in a case the amplitude of a sample (a sample value) is large and the amplitude is greatly increased in a case the amplitude of the sample is small, for example. The reproduction level of an audio signal can thereby be effectively enhanced in such a way as to prevent the volume of a sound with high volume from greatly changing while converting a sound with low volume into a sound with higher volume.

Also, since the mapping control information α that determines the characteristic of a mapping function is decided using a mapping control model that is obtained for each audio signal processing device 11 by learning, amplitude conversion that is optimal for each audio signal processing device 11 or each user can be performed.

Furthermore, by appropriately setting the mapping function f(x), the dynamic range of the volume of a sound can be made wider, be left unchanged or be made narrower by amplitude conversion.

In this manner, with the audio signal processing device 11, the reproduction level of an audio signal can be easily and effectively enhanced.

Additionally, the mapping function f(x) used for the mapping process is not limited to a non-linear function, and may be any function, such as a linear function, an exponential function or the like, as long as $-1 \leq f(x) \leq 1$ is true for a sample value x for which $-1 \leq x \leq 1$ stands. For example, a function with which the effect of the mapping process is highly evaluated or is suitable with respect to the sense of hearing may be used as the mapping function.

Furthermore, the mapping process may be performed by calculating the mapping control information for a set of two or more consecutive samples of an input signal instead of calculating the mapping control information for each sample of the input signal.

Returning to the explanation of the flow chart of FIG. 6, after generating an output signal by the mapping process, the mapping processing unit 24 supplies the output signal obtained to the output unit 25.

In step S44, the output unit 25 outputs the output signal supplied by the mapping processing unit 24 to the latter stage, and the conversion process is ended. The output unit 25 also supplies the output signal to the drive 26 as necessary, and the drive 26 records the output signal supplied in the removable media 27.

As described above, the audio signal processing device 11 analyses the characteristic of an input signal, performs a mapping process on the input signal using a mapping function that changes according to the analysis result, and generates an output signal.

The root mean square RMS(n) as an analysis feature obtained by analyzing an input signal shows the size of an average sample value in a predetermined section of the input signal, that is, the distribution of the amplitude of samples in the predetermined section. For example, in the case the root mean square RMS(n) is small, the input signal includes many samples with small amplitude, and in the case the root mean square RMS(n) is large, the input signal includes many samples with large amplitude.

With the audio signal processing device 11, an input signal can be easily converted into an output signal having an ideal distribution of amplitude by generating, by using the root mean square RMS(n), a mapping function with a more effective characteristic and performing the mapping process.

Moreover, the mapping control model, used by the audio signal processing device 11, for obtaining the mapping control information from an analysis feature is created for each audio signal processing device 11 or each user based on a previous statistical analysis. Thus, optimal reproduction level control can be realized for each audio signal processing device 11 or each user.

<Modified Example 1>

[Example Configuration of Audio Signal Processing Device]

Additionally, a case where learning of the mapping control model is performed by the learning device 51 has been described above, but a function for performing learning of the mapping control model may also be provided within the audio signal processing device.

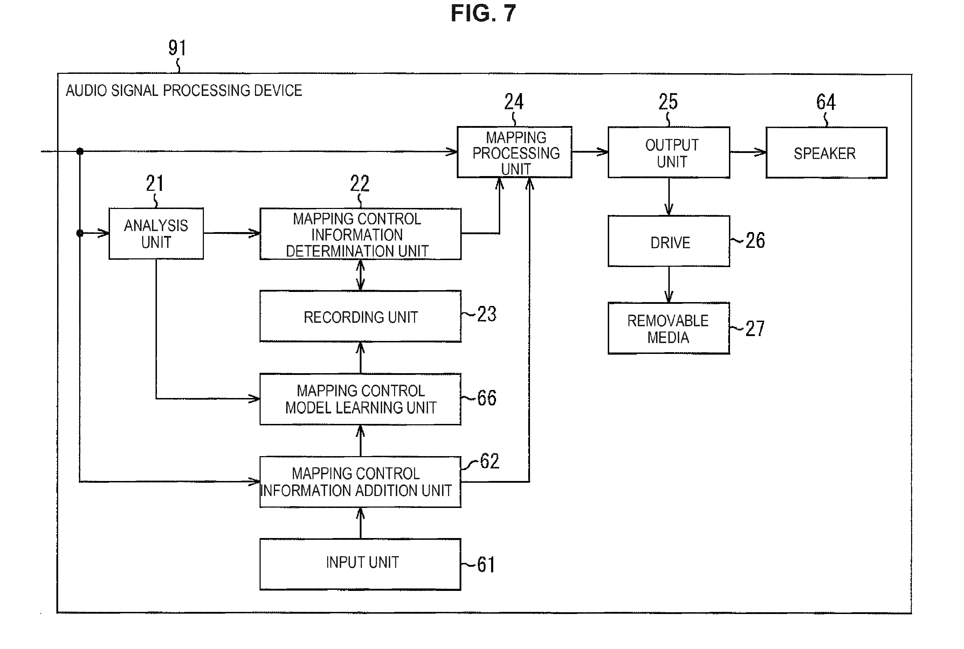

In such a case, the audio signal processing device is configured as shown in FIG. 7, for example. Additionally, in FIG. 7, parts corresponding to those in FIGS. 1 and 2 are denoted with the same numerals, and explanation thereof is omitted as appropriate.

An audio signal processing device 91 is configured from an analysis unit 21, a mapping control information determination unit 22, a recording unit 23, a mapping processing unit 24, an output unit 25, a drive 26, a speaker 64, an input unit 61, a mapping control information addition unit 62 and a mapping control model learning unit 66.

With this audio signal processing device 91, an audio signal as the input signal to be reproduced or as the learning sound-source signal to be used for learning is supplied to the mapping processing unit 24, the analysis unit 21 and the mapping control information addition unit 62. Furthermore, the analysis unit 21 analyses the characteristic of the audio signal supplied, and supplies the analysis feature obtained as a result to the mapping control information determination unit 22 or the mapping control model learning unit 66.

Next, an operation of the audio signal processing device 91 will be described.

First, in the case of learning a mapping control model, the audio signal processing device 91 performs the learning process described with reference to FIG. 3.

That is, the mapping control information addition unit 62 adds mapping control information to a sample of the learning sound-source signal supplied, and supplies the mapping control information to the mapping processing unit 24. Then, the mapping processing unit 24 performs a mapping process on the learning sound-source signal supplied, by using the mapping control information from the mapping control information addition unit 62, and supplies a learning output signal thereby obtained to the speaker 64 via the output unit 25 and causes it to be reproduced.

A user who has listened to the sound output from the speaker 64 operates the input unit 61 to thereby adjust the mapping control information added, or cause the mapping control information added to be fixed, for example. When optimal mapping control information is selected by the user, the mapping control information addition unit 62 supplies the mapping control information added, to the mapping control model learning unit 66.

Also, the analysis unit 21 analyses the learning sound-source signal supplied, and supplies the obtained analysis feature to the mapping control model learning unit 66. Then, the mapping control model learning unit 66 creates a mapping control model by learning that uses the analysis feature from the analysis unit 21 and the mapping control information from the mapping control information addition unit 62, and causes the recording unit 23 to record the same.

When a mapping control model is obtained in this manner, a conversion process on the input signal is enabled. Next, a conversion process by the audio signal processing device 91 will be described. The audio signal processing device 91 performs the conversion process described with reference to FIG. 6.

That is, the analysis unit 21 analyses the characteristic of the input signal supplied, and supplies the obtained analysis feature to the mapping control information determination unit 22. The mapping control information determination unit 22 obtains mapping control information from the mapping control model recorded in the recording unit 23 and the analysis feature from the analysis unit 21, and supplies the same to the mapping processing unit 24.

The mapping processing unit 24 performs a mapping process on the input signal supplied, by using the mapping control information from the mapping control information determination unit 22, and supplies the obtained output signal to the output unit 25. The output signal supplied to the output unit 25 is supplied to the speaker 64 and is reproduced, or is supplied to the drive 26 and is recorded in the removable media 27, for example.

<Second Embodiment>

[Example Configuration of Audio Signal Processing Device]

Additionally, in the case there are two or more channels for the input signal, if the mapping process (amplitude conversion) on the input signal is performed separately for each channel, the volume balance between the channels for the input signal may change. Thus, in the case an audio signal having a plurality of channels is input as the input signal, the mapping process is desirably performed using mapping functions of the same characteristic for all the channels.

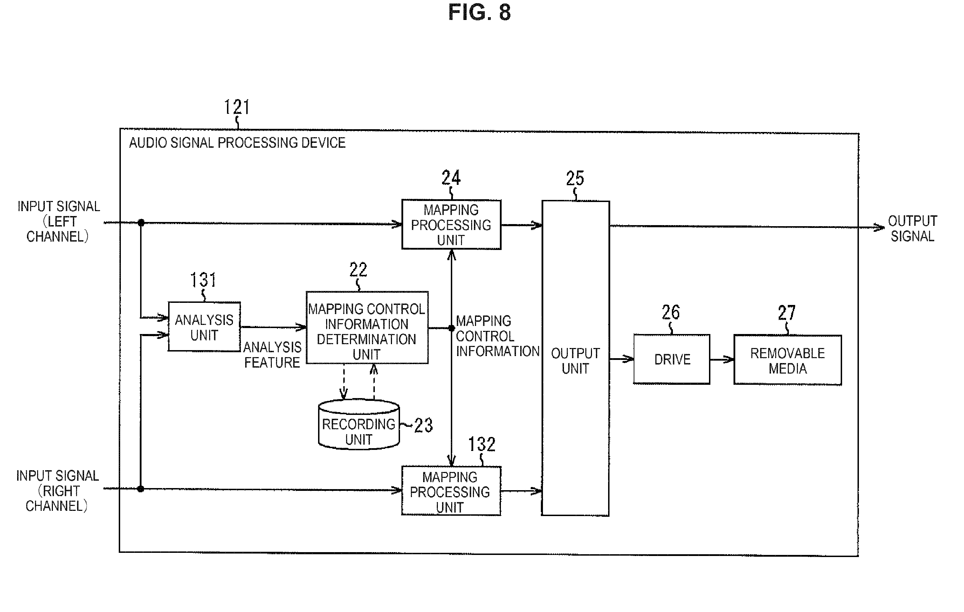

For example, in a case an audio signal (a stereo signal) having two channels, left and right, is to be input as the input signal and mapping processes that use mapping functions of the same characteristic are to be performed on respective channels, the audio signal processing device is configured as shown in FIG. 8. Additionally, in FIG. 8, parts corresponding to those in FIG. 1 are denoted with the same numerals, and explanation thereof is omitted as appropriate.

An audio signal processing device 121 of FIG. 8 is configured from an analysis unit 131, a mapping control information determination unit 22, a recording unit 23, a mapping processing unit 24, a mapping processing unit 132, an output unit 25 and a drive 26.

With the audio signal processing device 121, the input signal of the left channel is supplied to the analysis unit 131 and the mapping processing unit 24, and the input signal of the right channel is supplied to the analysis unit 131 and the mapping processing unit 132.

The analysis unit 131 analyses the characteristics of the input signals of the left and right channels which have been supplied, generates one analysis feature, and supplies the same to the mapping control information determination unit 22. Also, the mapping control information determination unit 22 obtains mapping control information which is common to the left and right channels from the analysis feature from the analysis unit 131, and supplies the same to the mapping processing unit 24 and the mapping processing unit 132.

The mapping processing unit 132 performs on the input signals supplied a mapping process that uses the mapping control information from the mapping control information determination unit 22, and supplies an output signal obtained as a result to the output unit 25.

[Explanation of Conversion Process]

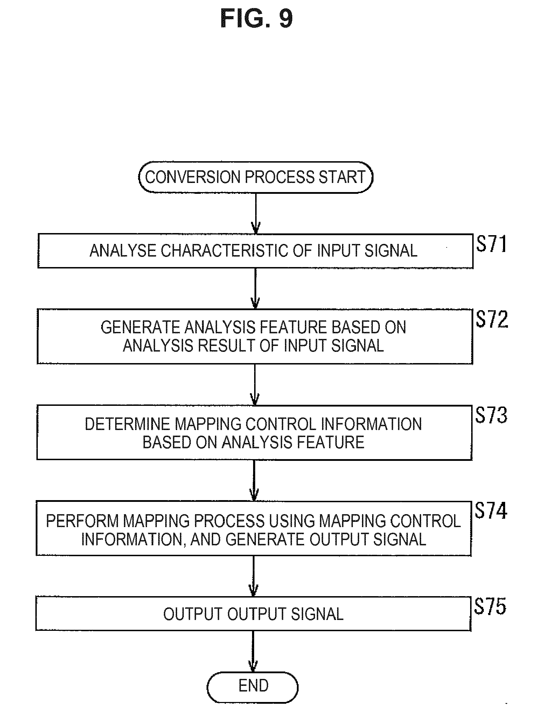

Next, a conversion process performed by the audio signal processing device 121 will be described with reference to the flow chart of FIG. 9.

In step S71, the analysis unit 131 analyses the characteristics of input signals of the left and right channels which have been supplied. For example, the analysis unit 131 performs the calculation of Formula (2) described above, and calculates the root mean square RMS(n) of the left channel and the root mean square RMS(n) of the right channel.

In step S72, the analysis unit 131 generates an analysis feature based on the analysis results of the characteristics of the input signals, and supplies the same to the mapping control information determination unit 22. For example, the analysis unit 131 obtains the average value of the root mean square RMS(n) of the left channel and the root mean square RMS(n) of the right channel, and takes the average value obtained as the analysis feature.

Additionally, the larger value or the smaller value of the root mean square RMS(n) of the left channel and the root mean square RMS(n) of the right channel may also be taken as it is as the analysis feature.

When the process of step S72 is performed and an analysis feature is generated, the processes of steps S73 to S75 are then performed, and the conversion process is ended. These processes are the same as the processes of steps S42 to S44 of FIG. 6, and explanation thereof is omitted.

Additionally, in step S74, the output signal of the left channel and the output signal of the right channel are generated respectively by the mapping processing unit 24 and the mapping processing unit 132 by using the same mapping control information and by the mapping functions of the same characteristic.

Then, in step S75, these output signals of the left and right channels are output to the latter stage or recorded in the removable media 27 via the drive 26, for example.

In this manner, the audio signal processing device 121 analyses the characteristics of the input signals of the left and right channels, generates mapping control information that is common to the left and right channels, and performs the same mapping process for each channel using the obtained mapping control information. By using mapping control information that is common to the left and right channels and performing the same mapping process on the input signals of respective channels, the reproduction level of the audio signal can be enhanced without changing the volume balance between the channels.

Additionally, a case where input signals of two channels, left and right, are input has been described above, but also in the case of the input signal with three or more channels, mapping control information that is common to all the channels is generated.

<Third Embodiment>

[Example Configuration of Audio Signal Processing Device]

Furthermore, the sound or music that is reproduced from the audio signal as the input signal has a different characteristic for each frequency band. Thus, if an analysis that is suitable for each band is performed on each frequency band, more appropriate mapping control information can be obtained from the obtained analysis features.

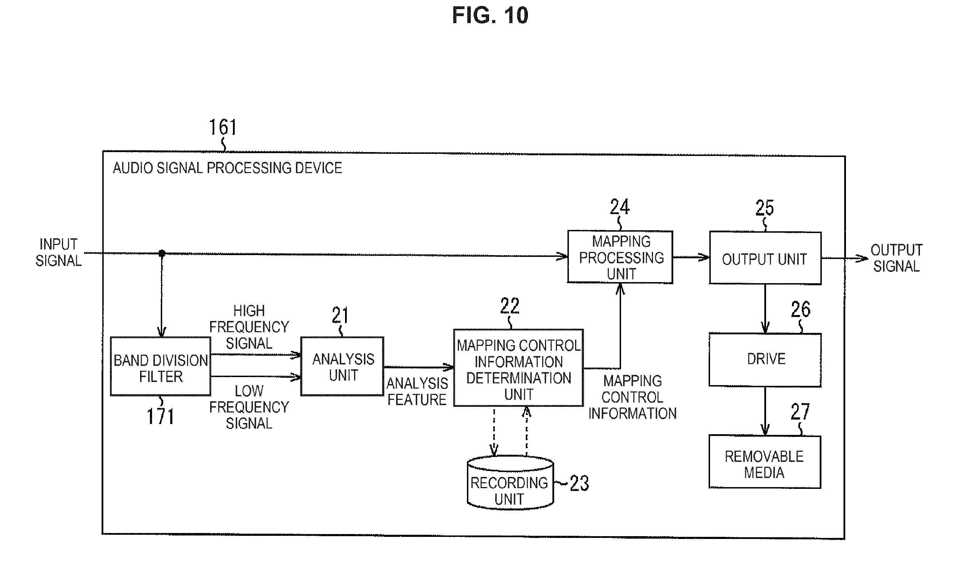

In the case an analysis feature is to be generated by performing an analysis of characteristic for each frequency band of an input signal, the audio signal processing device is configured as shown in FIG. 10, for example. Additionally, in FIG. 10, parts corresponding to those in FIG. 1 are denoted with the same numerals, and explanation thereof is omitted as appropriate.

An audio signal processing device 161 of FIG. 10 is configured from a band division filter 171, an analysis unit 21, a mapping control information determination unit 22, a recording unit 23, a mapping processing unit 24, an output unit 25 and a drive 26. Furthermore, an input signal supplied to the audio signal processing device 161 is supplied to the band division filter 171 and the mapping processing unit 24.

The band division filter 171 performs band division on the input signal supplied, divides the input signal into a high frequency component and a low frequency component, and supplies a high frequency signal, which is the high frequency component, and a low frequency signal, which is the low frequency component, to the analysis unit 21. The analysis unit 21 generates an analysis feature from the high frequency signal and the low frequency signal from the band division filter 171, and supplies the same to the mapping control information determination unit 22.

[Explanation of Conversion Process]

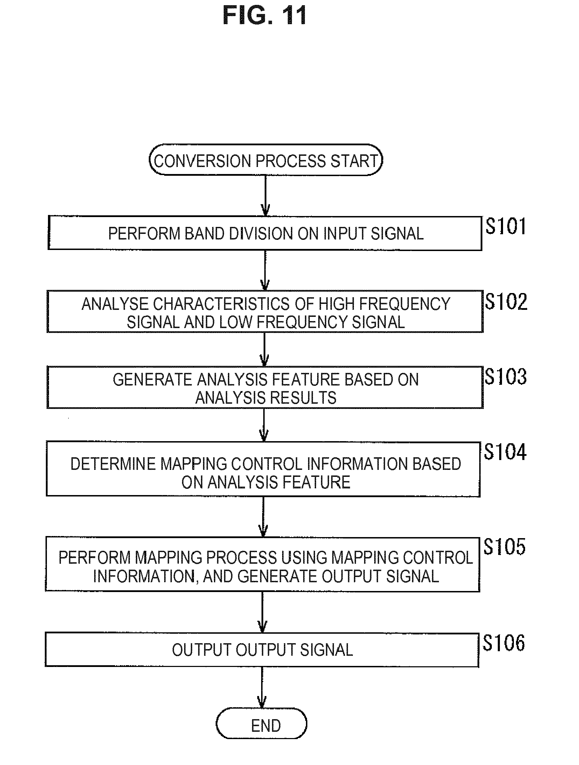

Next, a conversion process performed by the audio signal processing device 161 will be described with reference to the flow chart of FIG. 11.

In step S101, the band division filter 171 performs band division on an input signal which has been supplied, by performing a filtering process or the like, and supplies the high frequency signal and the low frequency signal obtained as a result to the analysis unit 21.

For example, the input signal is band-limited at a frequency of around 300 Hz, and is divided into a low frequency signal of a frequency component of 300 Hz or less and a high frequency signal of a frequency component of above 300 Hz.

Additionally, an example has been described where the frequency band of the input signal is divided into two at 300 Hz, but the band of the input signal may be divided at any frequency, such as 200 Hz, 400 Hz, 1 kHz or 3.4kHz. Also, the input signal may be divided into three or more frequency bands.

Furthermore, a signal in each frequency band may be obtained by converting the input signal into a signal in a frequency domain by Fourier transform or the like, and then, dividing the signal into a component in each frequency band and causing the component in each frequency band after division to be a time signal in each frequency band by inverse Fourier transform or the like.

In step S102, the analysis unit 21 analyses the characteristics of the high frequency signal and the low frequency signal supplied from the band division filter 171.

For example, the analysis unit 21 performs the calculation of Formula (4) below, and calculates a root mean square RMS_1(n) for an n-th sample of the low frequency signal.

$$\mathrm{RMS}_{\_l}(n) = 20.0 \times \log_{10}\left(\sqrt{\frac{1}{M} \cdot \sum_{m=n-M/2}^{n+M/2-1} (x_{\_l}(m))^2}\right) \quad \cdots (4)$$

Additionally, in Formula (4), $x_{\_1}(m)$ indicates the sample value of an m-th sample of the low frequency signal. Also, in Formula (4), the value of the low frequency signal, that is, the sample value of each sample of the low frequency signal, is assumed to have been normalized such that $-1 \leq x_{\_1}(m) \leq 1$ stands. The calculation of Formula (4) is a calculation for obtaining a root mean square for a section formed from M consecutive samples centring on the n-th sample.

Furthermore, the analysis unit 21 performs calculation of Formula (5) below, and calculates a root mean square RMS_h(n) for an n-th sample of the high frequency signal.

$$\mathrm{RMS}_{\_h}(n) = 20.0 \times \log_{10}\left(\sqrt{\frac{1}{N} \cdot \sum_{m=n-N/2}^{n+N/2-1} (x_{\_h}(m))^2}\right) \quad \cdots (5)$$

Additionally, in Formula (5), $x_{\_h}(m)$ indicates the sample value of an m-th sample of the high frequency signal. Also, in Formula (5), the value of the high frequency signal, that is, the sample value of each sample of the high frequency signal, is assumed to have been normalized such that $-1 \leq x_{\_h}(m) \leq 1$ stands. The calculation of Formula (5) is a calculation for obtaining a root mean square for a section formed from N consecutive samples centring on the n-th sample.

In this manner, at the analysis unit 21, a different analysis is performed on each of the low frequency signal and the high frequency signal.

Additionally, for the analysis of characteristic for the low frequency signal and the high frequency signal, the mean square value of the low frequency signal or the high frequency signal, a logged mean square value of the low frequency signal or the high frequency signal, the square root of the mean square value of the low frequency signal or the high frequency signal, the t-th power value (where t≥2) of a logged square root of the mean square value of the low frequency signal or the high frequency signal, or the like may be obtained. Alternatively, the zero-crossing rate of these signals, the slope of the frequency envelope or the like may also be obtained.

In step S103, the analysis unit 21 generates an analysis feature based on the analysis results of the characteristics of the high frequency signal and the low frequency signal, and supplies the same to the mapping control information determination unit 22.

For example, the analysis unit 21 performs the calculation of Formula (6) below, and calculates, as the analysis feature, a weighted added value of the root mean square RMS_1(n) and the root mean square RMS_h(n).

$$ \mathrm{RMS'}(n) = p \times \mathrm{RMS}\_l(n) + q \times \mathrm{RMS}\_h(n) \quad (p=q=0.5) \quad \cdots (6) $$

Additionally, in Formula (6), p and q indicate the weight, and p and q are assumed to be 0.5, for example. Also, the weights p and q for the analysis results of respective bands are assumed here to be the same value, but a larger weight may be assigned to an analysis result of a specific band.

An RMS'(n) obtained in this manner is taken as the analysis feature of the n-th sample of the input signal. When the analysis feature is generated, the processes of step S104 to S106 are performed and the conversion process is ended. These processes are the same as the processes of steps S42 to S44 of FIG. 6, and explanation thereof will be omitted.

As described, the audio signal processing device 161 analyses the characteristic for each frequency band of an input signal, and generates an analysis feature from the analysis results of the signals of respective frequency bands. Then, the audio signal processing device 161 performs a mapping process on the input signal by using the mapping control information that is obtained from the analysis feature, and generates an output signal.

By performing, with respect to each frequency band of the input signal, an analysis suitable for each frequency band, more appropriate mapping control information can be obtained from the analysis feature obtained. The reproduction level of the audio signal can thereby be effectively enhanced.

Additionally, a different analysis may be performed on the input signal and the signal of a frequency band, such as the high frequency signal and the low frequency signal, and an analysis feature may be generated from the analysis results. As the analysis feature, an analysis feature by which the effect of a mapping process will be highly evaluated, or an analysis feature that is suitable for mapping control may be used.

Now, in order to obtain mapping control information for converting the volume of sound of an input signal to ideal volume desired by a user, it is most adequate that the user himself/herself performs input or adjustment of the mapping control information.

Accordingly, the effect of the present technology can be checked, for example, by statistically evaluating the errors between pieces of mapping control information input by a plurality of users and each of the mapping control information obtained by the calculation using an analysis feature, without using the mapping control model obtained by statistical learning, and the mapping control information obtained by the present technology.

As a result of evaluation by the present applicant, it has been confirmed that more ideal mapping control information can be obtained by the method described in the first embodiment than by a method (hereinafter, referred to as a comparative method) of obtaining the mapping control information from an analysis feature without using a mapping control model. It has further been confirmed that more ideal mapping control information can be obtained by the method described in the third embodiment than the method described in the first embodiment.

Furthermore, it has been confirmed, also according to the subjective evaluation of output signals of the comparative method, the method described in the first embodiment and the method described in the third embodiment, that the method described in the first embodiment is more highly evaluated than the comparative method, and the method described in the third embodiment is more highly evaluated than the method described in the first embodiment. As described, according to the present technology, volume control that is more desirable to a user can be realized.

The series of processes described above may be performed by hardware or software. In the case of performing the series of processes by software, programs constituting the software are installed, from a program recording medium, on a computer that is incorporated in dedicated hardware, a general-purpose personal computer, for example, that is capable of performing various functions by installing various programs, or the like.

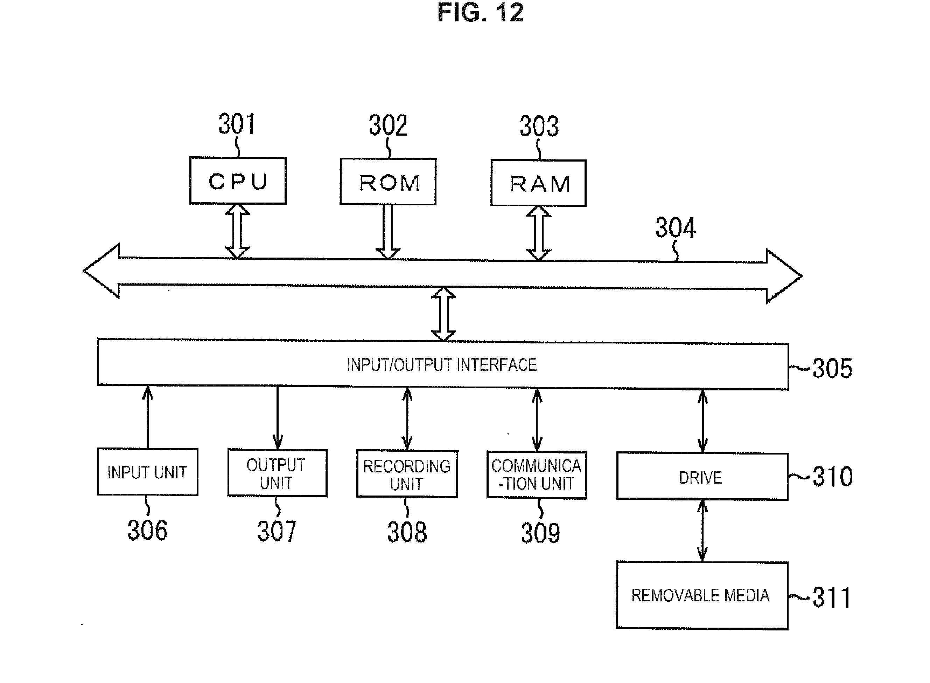

FIG. 12 is a block diagram showing an example configuration of the hardware of a computer that performs the series of processes described above by programs.

In the computer, a CPU (Central Processing Unit) 301, a ROM (Read Only Memory) 302 and a RAM (Random Access Memory) 303 are connected to each other via a bus 304.

An input/output interface 305 is also connected to the bus 304. Furthermore, connected to the input/output interface 305 are an input unit 306 configured from a keyboard, a mouse, a microphone or the like, an output unit 307 configured from a display, a speaker or the like, a recording unit 308 configured from a hard disk, a non-volatile memory or the like, a communication unit 309 configured from a network interface or the like, and a drive 310 for driving a removable media 311 such as a magnetic disk, an optical disk, a magneto-optical disk, a semiconductor memory or the like.

With a computer configured in the above manner, the series of processes described above is performed by the CPU 301 loading the programs recorded in the recording unit 308 on the RAM 303 via the input/output interface 305 and the bus 304 and executing the same, for example.

Programs to be executed by the computer (the CPU 301) are provided being recorded in the removable media 311, which is a packaged media configured from a magnetic disk (including a flexible disk), an optical disk (a CD-ROM (Compact Disc-Read Only Memory), a DVD (Digital Versatile Disc), or the like), a magneto-optical disk, a semiconductor memory or the like, or provided via a wired or wireless transmission medium, such as a local area network, the Internet or digital satellite broadcasting.

Then, the programs can be installed on the recording unit 308 via the input/output interface 305, by mounting the removable media 311 on the drive 310. Also, the programs can be received by the communication unit 309 via a wired or wireless transmission medium and be installed on the recording unit 308. Alternatively, the programs can be installed beforehand in the ROM 302 or the recording unit 308.

The programs to be executed by the computer may be programs according to which processes are performed chronologically according to the order described in the present specification, or they may be programs according to which processes are performed in parallel or at necessary timing, such as when there is a call up.

It should be understood by those skilled in the art that various modifications, combinations, subcombinations and alterations may occur depending on design requirements and other factors insofar as they are within the scope of the appended claims or the equivalents thereof.

Additionally, the present technology may also be configured as below.

(1)

A signal processing device including:

> an analysis unit for analyzing a characteristic of an input signal, and generating an analysis feature;
> a mapping control information determination unit for determining, based on the analysis feature and information that is generated by learning and that is for obtaining mapping control information from the analysis feature, the mapping control information; and
> a mapping processing unit for performing amplitude conversion on the input signal based on a linear or non-linear mapping function decided based on the mapping control information, and generating an output signal.

(2)

The signal processing device according to (1), wherein the information for obtaining the mapping control information has been learnt for each signal processing device.

(3)

The signal processing device according to (1) or (2), wherein the information for obtaining the mapping control information is information for obtaining a function for deriving the mapping control information from the analysis feature or a table for obtaining the mapping control information from the analysis feature.

(4)

The signal processing device according to (3), wherein the function includes a term which is uncorrelated to the analysis feature.

(5)

The signal processing device according to any of (1) to (4),
wherein the analysis unit analyses a characteristic of a learning sound-source signal for learning and generates the analysis feature, and
wherein the signal processing device further includes a learning unit for generating the information for obtaining the mapping control information by learning that uses the analysis feature of the learning sound-source signal and the mapping control information added to the learning sound-source signal by a user.

(6)

The signal processing device according to any of (1) to (5), wherein the analysis feature is a mean square of the input signal, a logged mean square of the input signal, a root mean square of the input signal, a logged root mean square of the input signal, or a zero-crossing rate of the input signal.

(7)

The signal processing device according to any of (1) to (5), wherein, in a case amplitude conversion on the input signal is performed for each of a plurality of channels, and the output signal of each channel is generated, the analysis unit generates one analysis feature that is common to every channel, based on the input signal of each of the plurality of channels.

(8)

The signal processing device according to any of (1) to (5), further including:
a band division unit for dividing the input signal into signals of a plurality of frequency bands,
wherein the analysis unit generates the analysis feature by performing weighted addition of mean squares of the signals, logged mean squares of the signals, root mean squares of the signals, or logged root mean squares of the signals.
In so far as the embodiments of the invention described above are implemented, at least in part, using software-controlled data processing apparatus, it will be appreciated that a computer program providing such software control and a transmission, storage or other medium by which such a computer program is provided are envisaged as aspects of the present invention.

**Claims**

1. A signal processing device comprising:

   an analysis unit for analyzing a characteristic of an input signal, and generating an analysis feature;
   a mapping control information determination unit for determining, based on the analysis feature and information that is generated by learning and that is for obtaining mapping control information from the analysis feature, the mapping control information; and
   a mapping processing unit for performing amplitude conversion on the input signal based on a linear or non-linear mapping function decided based on the mapping control information, and generating an output signal.

2. The signal processing device according to claim 1, wherein the information for obtaining the mapping control information has been learnt for each signal processing device.

3. The signal processing device according to claim 2, wherein the information for obtaining the mapping control information is information for obtaining a function for deriving the mapping control information from the analysis feature or a table for obtaining the mapping control information from the analysis feature.

4. The signal processing device according to claim 3, wherein the function includes a term which is uncorrelated to the analysis feature.

5. The signal processing device according to claim 4,
wherein the analysis unit analyses a characteristic of a learning sound-source signal for learning and generates the analysis feature, and

wherein the signal processing device further includes a learning unit for generating the information for obtaining the mapping control information by learning that uses the analysis feature of the learning sound-source signal and the mapping control information added to the learning sound-source signal by a user.

6. The signal processing device according to claim 5, wherein the analysis feature is a mean square of the input signal, a logged mean square of the input signal, a root mean square of the input signal, a logged root mean square of the input signal, or a zero-crossing rate of the input signal.

7. The signal processing device according to claim 5, wherein, in a case amplitude conversion on the input signal is performed for each of a plurality of channels, and the output signal of each channel is generated, the analysis unit generates one analysis feature that is common to every channel, based on the input signal of each of the plurality of channels.

8. The signal processing device according to claim 5, further comprising:

   a band division unit for dividing the input signal into signals of a plurality of frequency bands,

   wherein the analysis unit generates the analysis feature by performing weighted addition of mean squares of the signals, logged mean squares of the signals, root mean squares of the signals, or logged root mean squares of the signals.

9. A signal processing method of a signal processing device including an analysis unit for analyzing a characteristic of an input signal and generating an analysis feature, a mapping control information determination unit for determining, based on the analysis feature and information that is generated by learning and that is for obtaining mapping control information from the analysis feature, the mapping control information, and a mapping processing unit for performing amplitude conversion on the input signal based on a linear or non-linear mapping function decided based on the mapping control information and generating an output signal, comprising:

   generating the analysis feature by the analysis unit;
   determining the mapping control information by the mapping control information determination unit; and
   outputting the output signal by the mapping processing unit.

10. A program for causing a computer to perform processes including:

   analyzing a characteristic of an input signal, and generating an analysis feature;
   determining, based on the analysis feature and information that is generated by learning and that is for obtaining mapping control information from the analysis feature, the mapping control information; and
   performing amplitude conversion on the input signal based on a linear or non-linear mapping function decided based on the mapping control information, and generating an output signal.

11. A data recording medium recording an output signal obtained by:

   analyzing a characteristic of an input signal, and generating an analysis feature, determining, based on the analysis feature and information that is generated by learning and that is for obtaining mapping control information from the analysis feature, the mapping control information, and
   performing amplitude conversion on the input signal based on a linear or non-linear mapping function decided based on the mapping control information.

EP 2 518 897 A2

# FIG. 1

AUDIO SIGNAL PROCESSING DEVICE — 11

INPUT SIGNAL

ANALYSIS UNIT — 21

ANALYSIS FEATURE

MAPPING CONTROL INFORMATION DETERMINATION UNIT — 22

MAPPING CONTROL INFORMATION

RECORDING UNIT — 23

MAPPING PROCESSING UNIT — 24

OUTPUT UNIT — 25

OUTPUT SIGNAL

DRIVE — 26

REMOVABLE MEDIA — 27

# FIG. 2

LEARNING DEVICE 51

LEARNING SOUND-SOURCE SIGNAL →

MAPPING PROCESSING UNIT 63 → SPEAKER 64

MAPPING CONTROL INFORMATION ADDITION UNIT 62

INPUT UNIT 61

MAPPING CONTROL INFORMATION

ANALYSIS UNIT 65

ANALYSIS FEATURE

MAPPING CONTROL MODEL LEARNING UNIT 66

RECORDING UNIT 67

EP 2 518 897 A2

## FIG. 3

```
        ( LEARNING PROCESS START )
                     |
                     |
     ┌───────────────┼─────────────────────────┐
     │               ▼                          │
     │   ┌─────────────────────────────────┐    │
     │   │ RECEIVE INPUT OR ADJUSTMENT OF  │ S11│
     │   │   MAPPING CONTROL INFORMATION   │    │
     │   └─────────────────────────────────┘    │
     │               │                          │
     │               ▼                          │
     │   ┌─────────────────────────────────┐    │
     │   │  PERFORM MAPPING PROCESS USING  │ S12│
     │   │     MAPPING CONTROL INFORMATION │    │
     │   └─────────────────────────────────┘    │
     │               │                          │
     │               ▼                          │
     │   ┌─────────────────────────────────┐    │
     │   │  REPRODUCE LEARNING OUTPUT SIGNAL│S13 │
     │   └─────────────────────────────────┘    │
     │               │                          │
     │               ▼          S14             │
     │         ╱ OPTIMAL ╲                      │
     │        ╱  MAPPING    ╲                    │
     │       ╱ CONTROL INFO   ╲───── NO ─────────┘
     │        ╲ IS OBTAINED? ╱
     │         ╲           ╱
     │              │ YES
     │              ▼
     │   ┌─────────────────────────────────┐
     │   │  SUPPLY MAPPING CONTROL INFORMATION│S15
     │   └─────────────────────────────────┘
     │              │
     │              ▼
     │   ┌─────────────────────────────────┐
     │   │ANALYSE CHARACTERISTIC OF LEARNING│S16
     │   │SOUND-SOURCE SIGNAL, AND GENERATE │
     │   │       ANALYSIS FEATURE          │
     │   └─────────────────────────────────┘
     │              │
     │              ▼       S17
     │         ╱ ENOUGH PIECES ╲
     └── NO ──╱  OF MAPPING      ╲
             ╲ CONTROL INFORMATION╱
              ╲  ARE OBTAINED?   ╱
                    │ YES
                    ▼
         ┌─────────────────────────────┐
         │  LEARN MAPPING CONTROL MODEL │S18
         └─────────────────────────────┘
                    │
                    ▼
                 ( END )
```

FIG. 4

EP 2 518 897 A2

# FIG. 5

EP 2 518 897 A2

# FIG. 6

```
CONVERSION PROCESS START
```

ANALYSE CHARACTERISTIC OF INPUT SIGNAL,
AND GENERATE ANALYSIS FEATURE — S41

DETERMINE MAPPING CONTROL INFORMATION BASED
ON ANALYSIS FEATURE — S42

PERFORM MAPPING PROCESS USING MAPPING CONTROL
INFORMATION, AND GENERATE OUTPUT SIGNAL — S43

OUTPUT OUTPUT SIGNAL — S44

```
END
```

# FIG. 7

EP 2 518 897 A2

## FIG. 8

EP 2 518 897 A2

# FIG. 9

CONVERSION PROCESS START

ANALYSE CHARACTERISTIC OF INPUT SIGNAL S71

GENERATE ANALYSIS FEATURE BASED ON ANALYSIS RESULT OF INPUT SIGNAL S72

DETERMINE MAPPING CONTROL INFORMATION BASED ON ANALYSIS FEATURE S73

PERFORM MAPPING PROCESS USING MAPPING CONTROL INFORMATION, AND GENERATE OUTPUT SIGNAL S74

OUTPUT OUTPUT SIGNAL S75

END

**FIG. 10**

AUDIO SIGNAL PROCESSING DEVICE 161

INPUT SIGNAL → BAND DIVISION FILTER 171

HIGH FREQUENCY SIGNAL → ANALYSIS UNIT 21

LOW FREQUENCY SIGNAL

ANALYSIS FEATURE → MAPPING CONTROL INFORMATION DETERMINATION UNIT 22

RECORDING UNIT 23

MAPPING CONTROL INFORMATION → MAPPING PROCESSING UNIT 24

OUTPUT UNIT 25 → OUTPUT SIGNAL

DRIVE 26

REMOVABLE MEDIA 27

EP 2 518 897 A2

# FIG. 11

```
( CONVERSION PROCESS START )
            │
            ▼
┌──────────────────────────────────────────────────┐
│   PERFORM BAND DIVISION ON INPUT SIGNAL            │  S101
└──────────────────────────────────────────────────┘
            │
            ▼
┌──────────────────────────────────────────────────┐
│   ANALYSE CHARACTERISTICS OF HIGH FREQUENCY        │  S102
│   SIGNAL AND LOW FREQUENCY SIGNAL                  │
└──────────────────────────────────────────────────┘
            │
            ▼
┌──────────────────────────────────────────────────┐
│   GENERATE ANALYSIS FEATURE BASED ON               │  S103
│   ANALYSIS RESULTS                                 │
└──────────────────────────────────────────────────┘
            │
            ▼
┌──────────────────────────────────────────────────┐
│   DETERMINE MAPPING CONTROL INFORMATION BASED      │  S104
│   ON ANALYSIS FEATURE                              │
└──────────────────────────────────────────────────┘
            │
            ▼
┌──────────────────────────────────────────────────┐
│   PERFORM MAPPING PROCESS USING MAPPING CONTROL    │  S105
│   INFORMATION, AND GENERATE OUTPUT SIGNAL          │
└──────────────────────────────────────────────────┘
            │
            ▼
┌──────────────────────────────────────────────────┐
│   OUTPUT OUTPUT SIGNAL                             │  S106
└──────────────────────────────────────────────────┘
            │
            ▼
        (  END  )
```

# FIG. 12

301 CPU

302 ROM

303 RAM

304

INPUT/OUTPUT INTERFACE —305

INPUT UNIT

OUTPUT UNIT

RECORDING UNIT

COMMUNICA-TION UNIT

DRIVE —310

306

307

308

309

REMOVABLE MEDIA —311

EP 2 518 897 A2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H05275950 A